# EUROPEAN PATENT SPECIFICATION

(11) **EP 4 614 173 B1**
(45) Date of publication and mention of the grant of the patent: **04.11.2026**
(21) Application number: 24189353.6
(22) Date of filing: 18.07.2024
(51) Int. Cl.: G01R 31/40, G01R 31/58, H04L 43/50

(54) **NEW POE & CABLE TESTER WITH BT STANDARD TEST**
NEUER POE- UND KABELTESTER MIT BT-STANDARDTEST
NOUVEAU TESTEUR DE CÂBLE POE ET DE TEST DE NORME BT

(30) Priority: 08.03.2024 CN 202420449764 U
(43) Date of publication of application: 10.09.2025
(73) Proprietor: Shenzhen Noyafa Electronic Co., Ltd., Shenzhen (CN)
(72) Inventor: Wu, Haiyan, Shenzhen (CN); Lei, Ming, Shenzhen (CN); Zhang, Jianping, Shenzhen (CN)
(74) Representative: Petraz, Gilberto Luigi

(56) References cited:
- CN-U- 213 633 550
- CN-U- 217 656 633
- US-B1- 10 481 216

## Description

### Field

The present disclosure relates to a cable tester and, particularly, a new POE & cable tester with BT standard test.

### Background

POE (Power over Ethernet) is a technology that allows power and data signals to be transmitted to remote devices over an Ethernet network without additional power cables, and the technology is widely used in many applications, especially in devices such as webcams, IP phones, and wireless access points.

IEEE 802.3af and IEEE 802.3at are two POE-related standards that define specifications for transmitting power over Ethernet cables. These standards enable devices to transmit both data and power over a single Ethernet connection, providing easier installation and maintenance for devices such as IP phones, webcams, and wireless access points. IEEE 802.3af, released in 2003, the very first POE, has a maximum power of 15.4W, a voltage range of 37-57V, and an operating mode that uses one of the two pairs of Ethernet cables for power transmission. The IEEE 802.3af standard enables up to 15.4W of power to be supplied to the device and defines a communication protocol between the PSE (Power Sourcing Equipment) and the PD (Powered Device) in order to negotiate the power requirements when connecting.

IEEE 802.3at, released in 2009 and also known as POE+, has a maximum power of 30W, a voltage range of 42.5-57V, and an operating mode that uses all four pairs of Ethernet cables simultaneously for power transmission. IEEE 802.3at enhances the requirements for power transmission by providing up to 30W. It supports power transmission using the wires in all four pairs of Ethernet cables, improving the efficiency and reliability of power transmission.

The introduction of these two standards enables a variety of devices to be supplied with power more flexibly over Ethernet connections, which is important for reducing deployment and maintenance costs, especially in scenarios where power needs to be transmitted over long distances, and it facilitates the wider use of POE technology.

IEEE 802.3bt is a standard related to POE, which is a further development of IEEE 802.3af and IEEE 802.3at, providing the ability to transmit power at higher power levels. Often referred to as POE++, this standard allows higher power to be transmitted over Ethernet cables to meet the requirements of devices with higher power needs. IEEE 802.3bt, released in 2018, has a maximum power of up to 71W or more, specifically depending on the type of device and its needs, and the 802.3bt standard specifies a wide range of voltage to accommodate the power needs of different devices. Similar to the 802.3at standard, 802.3bt uses the wires in all four pairs of Ethernet cables for power transmission to improve efficiency and reliability. The introduction of the IEEE 802.3bt standard enables POE technology to better meet the needs of devices with high power requirements, such as some high-performance cameras, wireless access points, and electric vehicle charging piles, which further promotes the widespread use of POE technology in various fields.

A cable tester is a device used to test the performance and quality of cables, which is commonly used in networking, communications, power, and other fields that require the use of cables to transmit signals or power. Cable testers detect and diagnose a variety of problems in cables, such as resistance, inductance, capacity, short-circuits, and break-circuits, to ensure the stability and reliability of the cable network. At present, the cable tester with POE test standard sold on the market is commonly only to test the IEEE 802.3af/at standard, and unable to test the POE switch with IEEE 802.3bt standard. US10481216 discloses a power testing device includes a communication port with pins that receive signals from a device under test.

### Summary

In view of the aforementioned deficiencies that the cable tester of the prior art is unable to test the POE switch with IEEE 802.3bt standard, provided in the present disclosure is a new POE & cable tester with BT standard test, which adopts a power management module together with an optocoupler detection module in a circuit structure, which solves the aforementioned problems.

The invention is set out in the appended set of claims.

The beneficial effects of the present disclosure are as follows. The present disclosure is introduced based on the market demand for testing IEEE 802.3bt standard POE switch, which allows testing IEEE 802.3bt standard POE switch standard, and allows the screening of POE switch standard with RJ45/RJ11 connector.

The present disclosure is further described below in conjunction with the attached drawings and the specific implementations.

### Brief description of the drawings

Fig. 1 is a circuit block diagram of the present disclosure.
Fig. 2 is a circuit diagram of the power management module part of the present disclosure.
Fig. 3 is a circuit diagram of the optocoupler detection module part of the present disclosure.
Fig. 4 is a circuit diagram of the interface module part of the present disclosure.
Fig. 5 is a circuit diagram of the central control module part of the present disclosure.
Fig. 6 is a circuit diagram of the display interface part of the present disclosure.

### Detailed description of the embodiments

The present embodiment is a preferred embodiment of the present disclosure, and any other basic structure that is the same as the present embodiment falls within the scope of protection of the present disclosure as defined by the claims.

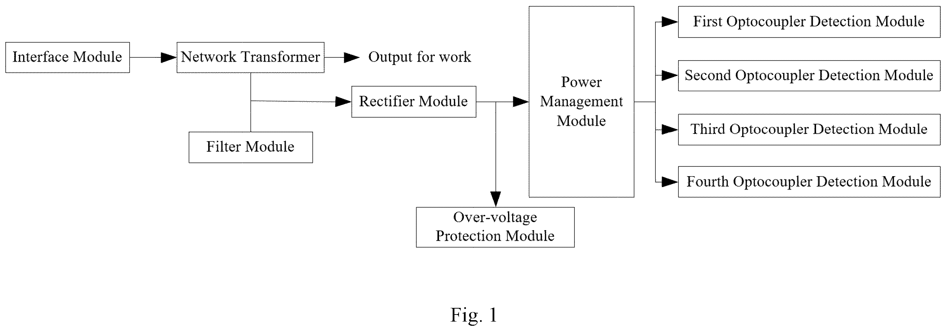

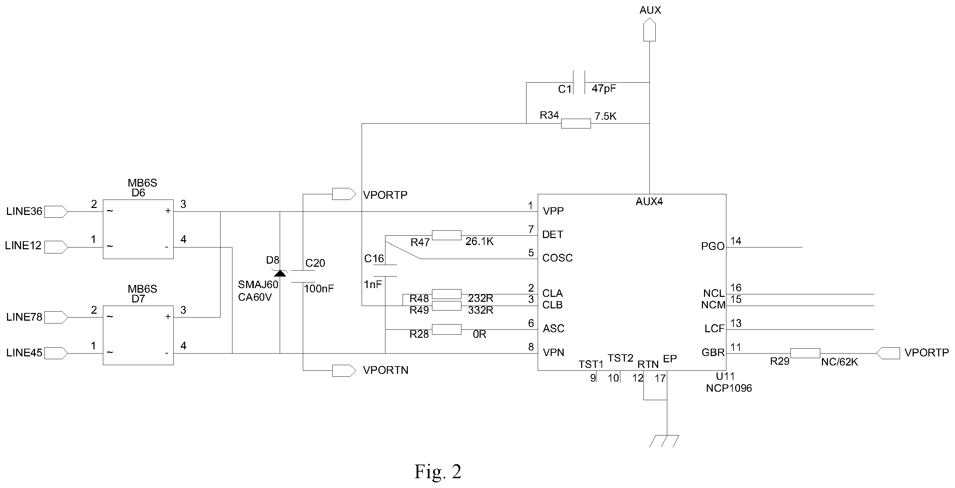

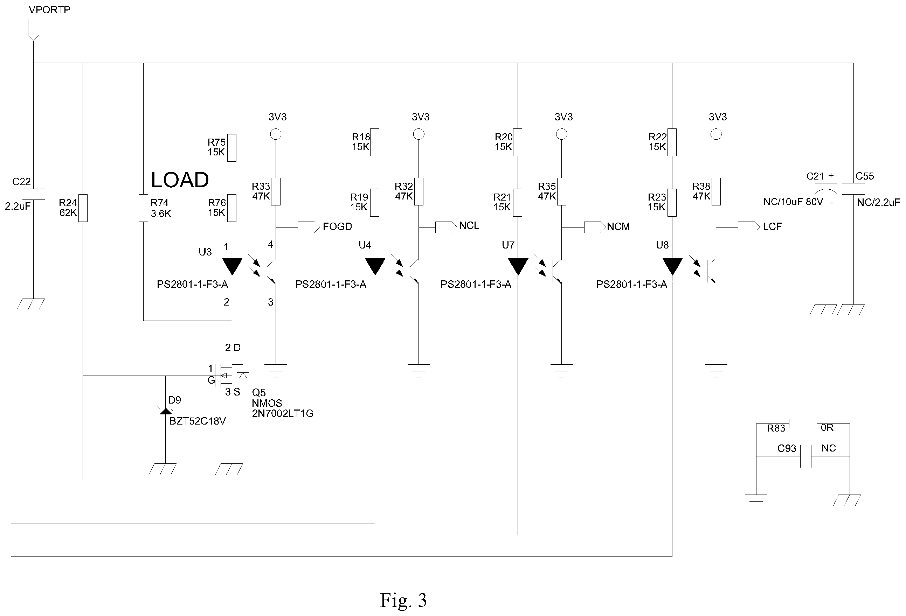

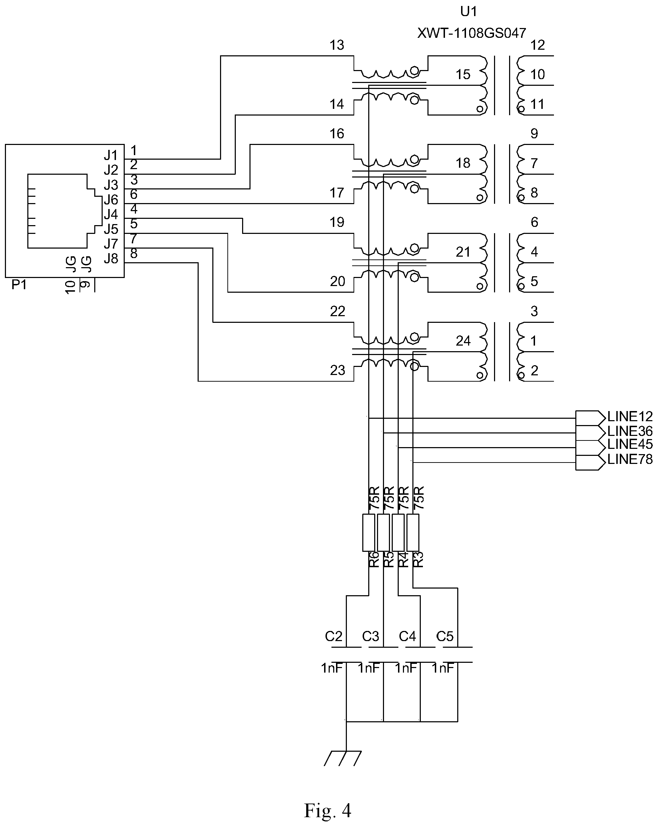

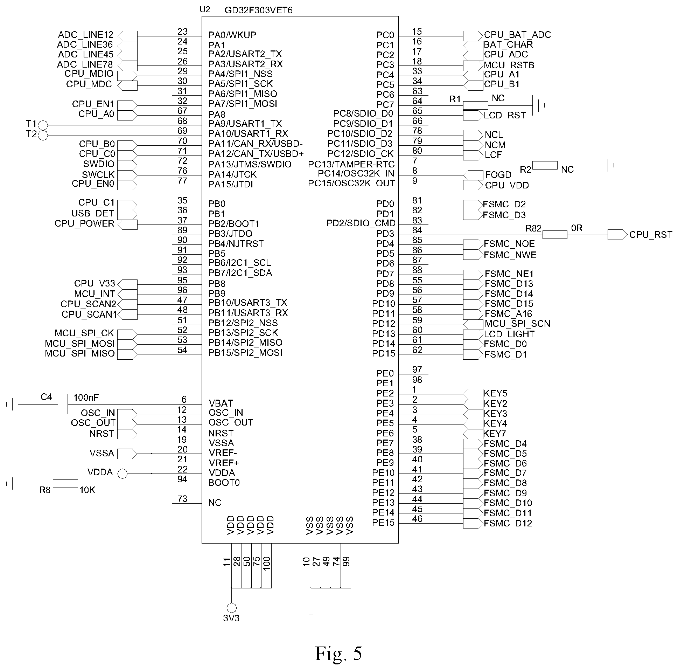

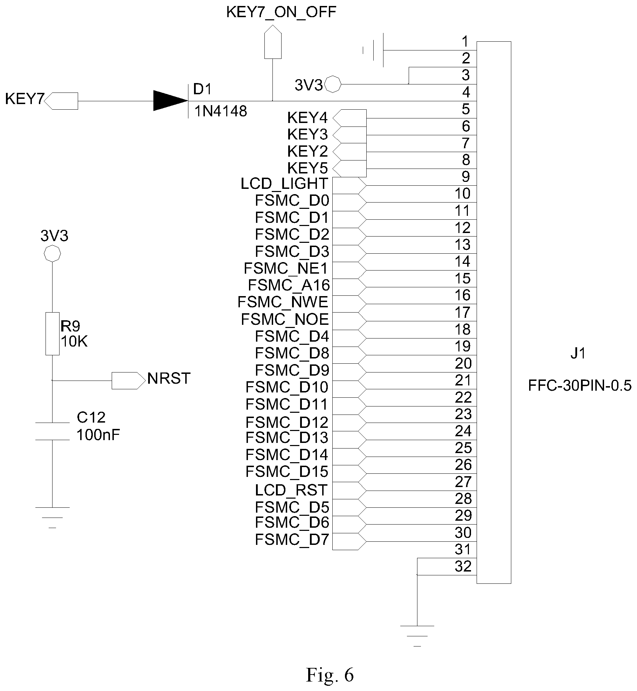

Referring to Figs. 1-6, protected in the present disclosure is a new POE & cable tester with BT standard test, mainly including an interface module, a network transformer U1, a rectifier module, a power management module, and at least one optocoupler detection module, wherein the interface module is connected to a primary coil, a secondary coil output port of the network transformer U1 is connected to a line testing module, a center tap of the network transformer U1 is connected to the rectifier module, the power management module is connected to an output port of the rectifier module, the power management module is connected to at least one optocoupler detection module respectively, and the optocoupler detection module is connected to a data port of a central control module.

In the present embodiment, the line testing module may adopt port flashing, length measurement, voltage measurement or other modules for detecting cable functions. The focus of the present disclosure is to adopt the primary coil to complete the detection of BT, and the line testing module may adopt the conventional cable detection module in the prior art.

In the present embodiment, the central control module adopts the microcontroller chip U2 of model GD32F303VET6, and may be replaced by other models of microcontroller chips in specific implementations, which is only required to satisfy that the outputs of 4 optocoupler detection modules may be simultaneously detected to determine the standard of POE. The central control module requires at least four ordinary I/O ports to complete it, while other peripheral circuits are designed according to other line testing functions.

In the present embodiment, the interface module adopts an RJ-45 interface P1, which may also be replaced with other interfaces according to the actual situation in the specific implementation.

In the present embodiment, the network transformer U1 is a network transformer of model XWT-1108GS047, which may be replaced by other models of network transformers with the same function in specific implementations.

In the present embodiment, the center tap of the network transformer U1 is connected with a filter module, the filter module adopts series-connected RC filters. Since an RJ-45 interface is adopted in the present embodiment, the network transformer U1 has four center taps, and each center tap is connected with a set of filter module. Taking the first set as an example to illustrate the circuit structure, the other filter modules have the same circuit structure as the first group. The first set of filter module includes a resistor R6 and a capacitor C2, a port of the resistor R6 is connected to a first center tap of the network transformer U1, an opposite port of the resistor R6 is connected to a port of the capacitor C2, an opposite port of the capacitor C2 is grounded, and the rectifier module is connected to a connection port between the resistor R6 and the center tap of the network transformer U1.

In the present embodiment, the rectifier module adopts a bridge rectifier D6 and a bridge rectifier D7. The bridge rectifier D6 and the bridge rectifier D7 both adopt the bridge rectifier chip with the model number MB6S, and may be replaced by other models of network transformers with the same function in specific implementations. A positive output port of the bridge rectifier D6 is connected to a positive output port of the bridge rectifier D7, and a negative output port of the bridge rectifier D6 is connected to a negative output port of the bridge rectifier D7.

In the present embodiment, an output port of the rectifier module is connected with an over-voltage protection module. The over-voltage protection module adopts a TVS tube D8 of model SMAJ60CA60, and may be replaced by other models or other types of over-voltage protection modules in specific implementations.

In the present embodiment, the positive output port (i.e., the VPORTP end) of the rectifier module is connected to each optocoupler detection module.

In the present embodiment, the positive output port (i.e., the VPORTP end) of the rectifier module is connected to the GBR interface of the power management module.

In the present embodiment, the power management module adopts the PoE-PD interface controller U11 of model NCP1096, and may be replaced by other models of chips with the same function in specific implementations. A VPN interface of the PoE-PD interface controller U11 is connected to a negative output port of the rectifier module, an ASC interface of the PoE-PD interface controller U11 is connected to the negative output port of the rectifier module via a resistor R28, a CLA interface of the PoE-PD interface controller U11 is connected to the negative output port of the rectifier module via a resistor R48, a CLB interface of the PoE-PD interface controller U11 is connected to the negative output port of the rectifier module via a resistor R49, a COSC interface of the PoE-PD interface controller U11 is connected to a port of a capacitor C16, the port of the capacitor C16 is connected to a DET interface of the PoE-PD interface controller U11 via a resistor R47, an opposite port of the capacitor C16 is connected to the negative output port of the rectifier module, an AUX interface of the PoE-PD interface controller U11 is connected to the negative output port of the rectifier module via a resistor R34, a capacitor C1 is connected in parallel to the resistor R34, an RTN interface and an EP interface of the PoE-PD interface controller U11 are grounded, a GBR interface of the PoE-PD interface controller U11 is connected to a positive output port (i.e., the VPORTP end) of the rectifier module via a resistor R29, and a PGO interface, an NCL interface, an NCM interface, an LCF interface of the PoE-PD interface controller U11 are each connected to one set of the optocoupler detection module.

In the present embodiment, provided are four sets of the optocoupler detection module; a first set of the optocoupler detection module includes a current limiting resistor R24, an MOS transistor Q5, a resistor R74, an optocoupler U3, a resistor R75, a resistor R76, and a resistor R33, a PGO interface of the PoE-PD interface controller U11 is connected to a positive output port of the rectifier module via the resistor R24, a gate of the MOS transistor Q5 is connected to the PGO interface of the PoE-PD interface controller U11, a source of the MOS transistor Q5 is grounded, a drain of the MOS transistor Q5 is connected to the positive output port of the rectifier module via a light-emitting diode of the optocoupler U3, the resistor R76, and the resistor R75 sequentially connected in series, the drain of the MOS transistor Q5 is connected to the positive output port of the rectifier module via the resistor R74, an emitter of a photosensitive triode of the optocoupler U3 is grounded, and a collector of the photosensitive triode of the optocoupler U3 is connected to a common I/O port of the central control module.

In the present embodiment, a filter capacitor C22 is connected between the positive output port of the rectifier module and ground.

In the present embodiment, a TVS tube D9 is connected between a gate of the MOS transistor Q5 and ground.

In the present embodiment, a second set of the optocoupler detection module includes an optocoupler U4, a resistor R18, a resistor R19, and a resistor R32, an NCL interface of the PoE-PD interface controller U11 is connected to the positive output port of the rectifier module via a light-emitting diode of the optocoupler U4, the resistor R19, the resistor R18 sequentially connected in series, an emitter of a photosensitive triode of the optocoupler U4 is grounded, a collector of the photosensitive triode of the optocoupler U4 is connected to a 3.3V power supply via the resistor R32, and the collector of the photosensitive triode of the optocoupler U4 is connected to a common I/O port of the central control module.

In the present embodiment, a third set of the optocoupler detection module includes an optocoupler U7, a resistor R21, a resistor R20, and a resistor R35, an NCM interface of the PoE-PD interface controller U11 is connected to the positive output port of the rectifier module via a light-emitting diode of the optocoupler U7, the resistor R21, and the resistor R20 sequentially connected in series, an emitter of a photosensitive triode of the optocoupler U7 is grounded, a collector of the photosensitive triode of the optocoupler U7 is connected to a 3.3V power supply via the resistor R35, and the collector of the photosensitive triode of the optocoupler U7 is connected to a common I/O port of the central control module.

In the present embodiment, a fourth set of optocoupler detection module includes an optocoupler U8, a resistor R23, a resistor R22, and a resistor R38, an LCF interface of the PoE-PD interface controller U11 is connected to the positive output port of the rectifier module via a light-emitting diode of the optocoupler U8, the resistor R23, and the resistor R22 sequentially connected in series, an emitter of a photosensitive triode of the optocoupler U8 is grounded, a collector of the photosensitive triode of the optocoupler U8 is connected to a 3.3V power supply via the resistor R38, and the collector of the photosensitive triode of the optocoupler U8 is connected to a common I/O port of the central control module.

The IEEE 802.3bt standard detection of the present disclosure is as follows: when the PSE device detects the PD device, it classifies the PD device, and responds to and completes the classification of all PSEs through the NCP1096 chip which has been set up with a power level. According to the power that the PSE device manages to provide to the PD, the NCP1096 labels the PSE and writes the result to the status output NCL NCM and LCF pins. The standard of the PSE device is judged by reading the electrical characteristics of the written status output NCL NCM and LCF pins.

When in use, the POE switch port is connected to the P1 port of the present disclosure via RJ45 terminal cable, and the NCP1096 chip is connected via rectifier, voltage regulator and filter, the NCP1096 chip performs the corresponding and marks the power that the switch manages to provide for the POE switch and writes the test results to the status output NCL NCM and LCF pins, which are isolated via optocoupler, and reads the electrical characteristics of the written status output NCL, NCM, and LCF pins to judge the standard of the PSE equipment.

The present disclosure is introduced based on the market demand for testing IEEE 802.3bt standard POE switch, which allows testing IEEE 802.3bt standard POE switch standard, and allows the screening of POE switch standard with RJ45/RJ11 connector.

## Claims

1. A power over ethernet, POE, & cable tester for a IEEE 802.3bt, BT standard test, comprising an interface module, a network transformer (U1), a rectifier module, a power management module, and at least one optocoupler detection module, **characterized in that** the interface module is connected to a primary coil of the network transformer (U1), a secondary coil output port of the network transformer (U1) is connected to a line testing module, a center tap of the primary coil of the network transformer (U1) is connected to an input port of the rectifier module, the power management module is connected to an output port of the rectifier module, the power management module is connected to input ports of at least one optocoupler detection module respectively, and output ports of the at least one optocoupler detection module are connected to a data port of a central control module.

2. The new POE & cable tester with BT standard test according to claim 1, wherein the center tap of the network transformer (U1) is connected with a filter module, the filter module adopts series-connected RC filters, each center tap is connected with a set of filter module, each set of filter modules comprises a resistor and a capacitor, a port of the resistor is connected to one center tap of the network transformer (U1), an opposite port of the resistor is connected to a port of the capacitor, an opposite port of the capacitor is grounded, and the rectifier module is connected to a connection port between the resistor and the center tap of the network transformer (U1).

3. The new POE & cable tester with BT standard test according to claim 1, wherein the rectifier module adopts a bridge rectifier (D6) and a bridge rectifier (D7), a positive output port of the bridge rectifier (D6) is connected to a positive output port of the bridge rectifier (D7), and a negative output port of the bridge rectifier (D6) is connected to a negative output port of the bridge rectifier (D7).

4. The new POE & cable tester with BT standard test according to claim 1, wherein an output port of the rectifier module is connected with an over-voltage protection module, and the over-voltage protection module adopts a TVS tube (D8).

5. The new POE & cable tester with BT standard test according to claim 1, wherein the power management module adopts a PoE-PD interface controller (U11), a VPN interface of the PoE-PD interface controller (U11) is connected to a negative output port of the rectifier module, an ASC interface of the PoE-PD interface controller (U11) is connected to the negative output port of the rectifier module via a resistor (R28), a CLA interface of the PoE-PD interface controller (U11) is connected to the negative output port of the rectifier module via a resistor (R48), a CLB interface of the PoE-PD interface controller (U11) is connected to the negative output port of the rectifier module via a resistor (R49), a COSC interface of the PoE-PD interface controller (U11) is connected to a port of a capacitor (C16), the port of the capacitor (C16) is connected to a DET interface of the PoE-PD interface controller (U11) via a resistor (R47), an opposite port of the capacitor (C16) is connected to the negative output port of the rectifier module, an AUX interface of the PoE-PD interface controller (U11) is connected to the negative output port of the rectifier module via a resistor (R34), a capacitor (C1) is connected in parallel to the resistor (R34), an RTN interface and an EP interface of the PoE-PD interface controller (U11) are grounded, a GBR interface of the PoE-PD interface controller (U11) is connected to a positive output port of the rectifier module via a resistor (R29), and a PGO interface, an NCL interface, an NCM interface, and an LCF interface of the PoE-PD interface controller (U11) are each connected to one set of the optocoupler detection module.

6. The new POE & cable tester with BT standard test according to claim 1, wherein provided are four sets of the optocoupler detection module; a first set of the optocoupler detection module comprises a current limiting resistor (R24), an MOS transistor (Q5), a resistor (R74), an optocoupler (U3), a resistor (R75), a resistor (R76), and a resistor (R33), a PGO interface of the PoE-PD interface controller (U11) is connected to a positive output port of the rectifier module via the resistor (R24), a gate of the MOS transistor (Q5) is connected to the PGO interface of the PoE-PD interface controller (U11), a source of the MOS transistor (Q5) is grounded, a drain of the MOS transistor (Q5) is connected to the positive output port of the rectifier module via a light-emitting diode of the optocoupler (U3), the resistor (R76), and the resistor (R75) sequentially connected in series, the drain of the MOS transistor (Q5) is connected to the positive output port of the rectifier module via the resistor (R74), an emitter of a photosensitive triode of the optocoupler (U3) is grounded, and a collector of the photosensitive triode of the optocoupler (U3) is connected to a common I/O port of the central control module;
a second set of the optocoupler detection module comprises an optocoupler (U4), a resistor (R18), a resistor (R19), and a resistor (R32), an NCL interface of the PoE-PD interface controller (U11) is connected to the positive output port of the rectifier module via a light-emitting diode of the optocoupler (U4), the resistor (R19), the resistor (R18) sequentially connected in series, an emitter of a photosensitive triode of the optocoupler (U4) is grounded, a collector of the photosensitive triode of the optocoupler (U4) is connected to a 3.3V power supply via the resistor (R32), and the collector of the photosensitive triode of the optocoupler (U4) is connected to a common I/O port of the central control module;
a third set of the optocoupler detection module comprises an optocoupler (U7), a resistor (R21), a resistor (R20), and a resistor (R35), an NCM interface of the PoE-PD interface controller (U11) is connected to the positive output port of the rectifier module via a light-emitting diode of the optocoupler (U7), the resistor (R21), and the resistor (R20) sequentially connected in series, an emitter of a photosensitive triode of the optocoupler (U7) is grounded, a collector of the photosensitive triode of the optocoupler (U7) is connected to a 3.3V power supply via the resistor (R35), and the collector of the photosensitive triode of the optocoupler (U7) is connected to a common I/O port of the central control module; and
a fourth set of optocoupler detection module comprises an optocoupler (U8), a resistor (R23), a resistor (R22), and a resistor (R38), an LCF interface of the PoE-PD interface controller (U11) is connected to the positive output port of the rectifier module via a light-emitting diode of the optocoupler (U8), the resistor (R23), and the resistor (R22) sequentially connected in series, an emitter of a photosensitive triode of the optocoupler (U8) is grounded, a collector of the photosensitive triode of the optocoupler (U8) is connected to a 3.3V power supply via the resistor (R38), and the collector of the photosensitive triode of the optocoupler (U8) is connected to a common I/O port of the central control module.

7. The new POE & cable tester with BT standard test according to claim 6, wherein a filter capacitor (C22) is connected between the positive output port of the rectifier module and ground.

8. The new POE & cable tester with BT standard test according to claim 1, wherein a TVS tube (D9) is connected between a gate of the MOS transistor (Q5) and ground.

## Patentansprüche

1. Stromversorgung über Ethernet, POE, und Kabeltester für einen IEEE 802.3bt - BT-Standardtest, umfassend ein Schnittstellenmodul, einen Netztransformator (U1), ein Gleichrichtermodul, ein Leistungsverwaltungsmodul und zumindest ein Optokopplerdetektionsmodul, **dadurch gekennzeichnet, dass** das Schnittstellenmodul mit einer Primärspule des Netztransformators (U1) verbunden ist, ein Sekundärspulenausgangsanschluss des Netztransformators (U1) mit einem Leitungstestmodul verbunden ist, ein Mittelabgriff der Primärspule des Netztransformators (U1) mit einem Eingangsanschluss des Gleichrichtermoduls verbunden ist, das Leistungsverwaltungsmodul mit einem Ausgangsanschluss des Gleichrichtermoduls verbunden ist, das Leistungsverwaltungsmodul jeweils mit Eingangsanschlüssen von zumindest einem Optokopplerdetektionsmodul verbunden ist, und Ausgangsanschlüsse des zumindest einen Optokopplerdetektionsmoduls mit einem Datenanschluss eines zentralen Steuerungsmoduls verbunden sind.

2. Neuer POE und Kabeltester mit BT-Standardtest nach Anspruch 1, worin der Mittelabgriff des Netztransformators (U1) mit einem Filtermodul verbunden ist, das Filtermodul in Serie geschaltete CR-Filter anwendet, jeder Mittelabgriff mit einem Satz von Filtermodul verbunden ist, jeder Satz von Filtermodulen einen Widerstand und einen Kondensator umfasst, ein Anschluss des Widerstands mit einem Mittelabgriff des Netztransformators (U1) verbunden ist, ein entgegengesetzter Anschluss des Widerstands mit einem Anschluss des Kondensators verbunden ist, ein entgegengesetzter Anschluss des Widerstands geerdet ist, und das Gleichrichtermodul mit einem Verbindungsanschluss zwischen dem Widerstand und dem Mittelabgriff des Netztransformators (U1) verbunden ist.

3. Neuer POE und Kabeltester mit BT-Standardtest nach Anspruch 1, worin das Gleichrichtermodul einen Brückengleichrichter (D6) und einen Brückengleichrichter (D7) anwendet, ein positiver Ausgangsanschluss des Brückengleichrichters (D6) mit einem positiven Ausgangsanschluss des Brückengleichrichters (D7) verbunden ist, und ein negativer Ausgangsanschluss des Brückengleichrichters (D6) mit einem negativen Ausgangsanschluss des Brückengleichrichters (D7) verbunden ist.

4. Neuer POE und Kabeltester mit BT-Standardtest nach Anspruch 1, worin ein Ausgangsanschluss des Gleichrichtermoduls mit einem Überspannungsschutzmodul verbunden ist, und das Überspannungsschutzmodul ein TVS-Rohr (D8) anwendet.

5. Neuer POE und Kabeltester mit BT-Standardtest nach Anspruch 1, worin das Leistungsverwaltungsmodul eine PoE-PD Schnittstellensteuerung (U11) anwendet, eine VPN Schnittstelle der PoE-PD Schnittstellensteuerung (U11) mit einem negativen Ausgangsanschluss des Gleichrichtermoduls verbunden ist, eine ASC Schnittstelle der PoE-PD Schnittstellensteuerung (U11) mit dem negativen Ausgangsanschluss des Gleichrichtermoduls über einen Widerstand (R28) verbunden ist, eine CLA Schnittstelle der PoE-PD Schnittstellensteuerung (U11) mit dem negativen Ausgangsanschluss des Gleichrichtermoduls über einen Widerstand (R48) verbunden ist, eine CLB Schnittstelle der PoE-PD Schnittstellensteuerung (U11) mit dem negativen Ausgangsanschluss des Gleichrichtermoduls über einen Widerstand (R49) verbunden ist, eine COSC Schnittstelle der PoE-PD Schnittstellensteuerung (U11) mit einem Anschluss eines Widerstands (C16) verbunden ist, der Anschluss des Widerstands (C16) mit einer DET Schnittstelle der PoE-PD Schnittstellensteuerung (U11) über einen Widerstand (R47) verbunden ist, ein entgegengesetzter Anschluss des Widerstands (C16) mit dem negativen Ausgangsanschluss des Gleichrichtermoduls verbunden ist, eine AUX Schnittstelle der PoE-PD Schnittstellensteuerung (U11) mit dem negativen Ausgangsanschluss des Gleichrichtermoduls über einen Widerstand (R34) verbunden ist, ein Kondensator (C1) mit dem Widerstand (R34) parallel verbunden ist, eine RTN Schnittstelle und eine EP Schnittstelle der PoE-PD Schnittstellensteuerung (U11) geerdet sind, eine GBR Schnittstelle der PoE-PD Schnittstellensteuerung (U11) mit einem positiven Ausgangsanschluss des Gleichrichtermoduls über einen Widerstand (R29) verbunden ist, und eine PGO Schnittstelle, eine NCL Schnittstelle, eine NCM Schnittstelle und eine LCF Schnittstelle der PoE-PD Schnittstellensteuerung (U11) je mit einem Satz des Optokopplerdetektionsmoduls verbunden sind.

6. Neuer POE und Kabeltester mit BT-Standardtest nach Anspruch 1, worin vier Sätze des Optokopplerdetektionsmoduls vorgesehen sind; ein erster Satz des Optokopplerdetektionsmoduls einen Strombegrenzungswiderstand (R24), einen MOS-Transistor (Q5), einen Widerstand (R74), einen Optokoppler (U3), einen Widerstand (R75), einen Widerstand (R76) und einen Widerstand (R33) umfasst, eine PGO-Schnittstelle der PoE-PD Schnittstellensteuerung (U11) mit einem positiven Ausgangsanschluss des Gleichrichtermoduls über den Widerstand (R24) verbunden ist, ein Gatter des MOS-Transistors (Q5) mit der PGO-Schnittstelle der PoE-PD Schnittstellensteuerung (U11) verbunden ist, eine Quelle des MOS-Transistors (Q5) geerdet ist, eine Senke des MOS-Transistors (Q5) mit dem positiven Ausgangsanschluss des Gleichrichtermoduls über eine lichtemittierende Diode des Optokopplers (U3) verbunden ist, der Widerstand (R76) und der Widerstand (R75) sequenziell in Serie verbunden sind, die Senke des MOS-Transistors (Q5) mit dem positiven Ausgangsanschluss des Gleichrichtermoduls über den Widerstand (R74) verbunden ist, ein Emitter einer fotosensitiven Triode des Optokopplers (U3) geerdet ist, und ein Kollektor der fotosensitiven Triode des Optokopplers (U3) mit einem gemeinsamen E/A-Anschluss des zentralen Steuerungsmoduls verbunden ist;
ein zweiter Satz des Optokopplerdetektionsmoduls einen Optokoppler (U4), einen Widerstand (R18), einen Widerstand (R19) und einen Widerstand (R32) umfasst, eine NCL Schnittstelle der PoE-PD Schnittstellensteuerung (U11) mit dem positiven Ausgangsanschluss des Gleichrichtermoduls über eine lichtemittierende Diode des Optokopplers (U4) verbunden ist, der Widerstand (R19) und der Widerstand (R18) sequenziell in Serie verbunden sind, ein Emitter einer fotosensitiven Triode des Optokopplers (U4) geerdet ist, ein Kollektor der fotosensitiven Triode des Optokopplers (U4) mit einer 3.3V Leistungsversorgung über den Widerstand (R32) verbunden ist, und der Kollektor der fotosensitiven Triode des Optokopplers (U4) mit einem gemeinsamen E/A-Anschluss des zentralen Steuerungsmoduls verbunden ist;
ein dritter Satz des Optokopplerdetektionsmoduls einen Optokoppler (U7), einen Widerstand (R21), einen Widerstand (R20) und einen Widerstand (R35) umfasst, eine NCM Schnittstelle der PoE-PD Schnittstellensteuerung (U11) mit dem positiven Ausgangsanschluss des Gleichrichtermoduls über eine lichtemittierende Diode des Optokopplers (U7) verbunden ist, der Widerstand (R21) und der Widerstand (R20) sequenziell in Serie verbunden sind, ein Emitter einer fotosensitiven Triode des Optokopplers (U7) geerdet ist, ein Kollektor der fotosensitiven Triode des Optokopplers (U7) mit einer 3.3V Leistungsversorgung über den Widerstand (R35) verbunden ist, und der Kollektor der fotosensitiven Triode des Optokopplers (U7) mit einem gemeinsamen E/A-Anschluss des zentralen Steuerungsmoduls verbunden ist; und
ein vierter Satz des Optokopplerdetektionsmoduls einen Optokoppler (U8), einen Widerstand (R23), einen Widerstand (R22) und einen Widerstand (R38) umfasst, eine LCF Schnittstelle der PoE-PD Schnittstellensteuerung (U11) mit dem positiven Ausgangsanschluss des Gleichrichtermoduls über eine lichtemittierende Diode des Optokopplers (U8) verbunden ist, der Widerstand (R23) und der Widerstand (R22) sequenziell in Serie verbunden sind, ein Emitter einer fotosensitiven Triode des Optokopplers (U8) geerdet ist, ein Kollektor der fotosensitiven Triode des Optokopplers (U8) mit einer 3.3V Leistungsversorgung über den Widerstand (R38) verbunden ist, und der Kollektor der fotosensitiven Triode des Optokopplers (U8) mit einem gemeinsamen E/A-Anschluss des zentralen Steuerungsmoduls verbunden ist.

7. Neuer POE und Kabeltester mit BT-Standardtest nach Anspruch 6, worin ein Filterkondensator (C22) zwischen dem positiven Ausgangsanschluss des Gleichrichtermoduls und Masse verbunden ist.

8. Neuer POE und Kabeltester mit BT-Standardtest nach Anspruch 1, worin ein TVS-Rohr (D9) zwischen einem Gatter des MOS-Transistors (Q5) und Masse verbunden ist.

## Revendications

1. Testeur d'alimentation par Ethernet, POE, & de câble pour un test de norme IEEE 802.3bt, BT, comprenant un module d'interface, un transformateur réseau (U1), un module redresseur, un module de gestion d'alimentation et au moins un module de détection à optocoupleur, **caractérisé en ce que** le module d'interface est connecté à un enroulement primaire du transformateur réseau (U1), un port de sortie d'enroulement secondaire du transformateur réseau (U1) est connecté à un module de test de ligne, une prise médiane de l'enroulement primaire du transformateur réseau (U1) est connectée à un port d'entrée du module redresseur, le module de gestion d'alimentation est connecté à un port de sortie du module redresseur, le module de gestion d'alimentation est connecté respectivement à des ports d'entrée d'au moins un module de détection à optocoupleur, et des ports de sortie de l'au moins un module de détection à optocoupleur sont connectés à un port de données d'un module de commande central.

2. Nouveau testeur POE & de câble avec test de norme BT selon la revendication 1, dans lequel la prise médiane du transformateur réseau (U1) est connectée à un module de filtrage, le module de filtrage adopte des filtres RC connectés en série, chaque prise médiane est connectée à un ensemble de module de filtrage, chaque ensemble de modules de filtrage comprend une résistance et un condensateur, un port de la résistance est connecté à une prise médiane du transformateur réseau (U1), un port opposé de la résistance est connecté à un port du condensateur, un port opposé du condensateur est mis à la masse, et le module redresseur est connecté à un port de connexion entre la résistance et la prise médiane du transformateur réseau (U1).

3. Nouveau testeur POE & de câble avec test de norme BT selon la revendication 1, dans lequel le module redresseur adopte un pont redresseur (D6) et un pont redresseur (D7), un port de sortie positif du pont redresseur (D6) est connecté à un port de sortie positif du pont redresseur (D7), et un port de sortie négatif du pont redresseur (D6) est connecté à un port de sortie négatif du pont redresseur (D7).

4. Nouveau testeur POE & de câble avec test de norme BT selon la revendication 1, dans lequel un port de sortie du module redresseur est connecté à un module de protection contre les surtensions, et le module de protection contre les surtensions adopte un tube TVS (D8).

5. Nouveau testeur POE & de câble avec test de norme BT selon la revendication 1, dans lequel le module de gestion d'alimentation adopte un contrôleur d'interface PoE-PD (U11), une interface VPN du contrôleur d'interface PoE-PD (U11) est connectée à un port de sortie négatif du module redresseur, une interface ASC du contrôleur d'interface PoE-PD (U11) est connectée au port de sortie négatif du module redresseur par l'intermédiaire d'une résistance (R28), une interface CLA du contrôleur d'interface PoE-PD (U11) est connectée au port de sortie négatif du module redresseur par l'intermédiaire d'une résistance (R48), une interface CLB du contrôleur d'interface PoE-PD (U11) est connectée au port de sortie négatif du module redresseur par l'intermédiaire d'une résistance (R49), une interface COSC du contrôleur d'interface PoE-PD (U11) est connectée à un port d'un condensateur (C16), le port du condensateur (C16) est connecté à une interface DET du contrôleur d'interface PoE-PD (U11) par l'intermédiaire d'une résistance (R47), un port opposé du condensateur (C16) est connecté au port de sortie négatif du module redresseur, une interface AUX du contrôleur d'interface PoE-PD (U11) est connectée au port de sortie négatif du module redresseur par l'intermédiaire d'une résistance (R34), un condensateur (C1) est connecté en parallèle avec la résistance (R34), une interface RTN et une interface EP du contrôleur d'interface PoE-PD (U11) sont mises à la masse, une interface GBR du contrôleur d'interface PoE-PD (U11) est connectée à un port de sortie positif du module redresseur par l'intermédiaire d'une résistance (R29), et une interface PGO, une interface NCL, une interface NCM et une interface LCF du contrôleur d'interface PoE-PD (U11) sont chacune connectées à un ensemble du module de détection à optocoupleur.

6. Nouveau testeur POE & de câble avec test de norme BT selon la revendication 1, dans lequel sont prévus quatre ensembles du module de détection à optocoupleur ; un premier ensemble du module de détection à optocoupleur comprend une résistance de limitation de courant (R24), un transistor MOS (Q5), une résistance (R74), un optocoupleur (U3), une résistance (R75), une résistance (R76) et une résistance (R33), une interface PGO du contrôleur d'interface PoE-PD (U11) est connectée à un port de sortie positif du module redresseur par l'intermédiaire de la résistance (R24), une grille du transistor MOS (Q5) est connectée à l'interface PGO du contrôleur d'interface PoE-PD (U11), une source du transistor MOS (Q5) est mise à la masse, un drain du transistor MOS (Q5) est connecté au port de sortie positif du module redresseur par l'intermédiaire d'une diode électroluminescente de l'optocoupleur (U3), de la résistance (R76) et de la résistance (R75) connectées successivement en série, le drain du transistor MOS (Q5) est connecté au port de sortie positif du module redresseur par l'intermédiaire de la résistance (R74), un émetteur d'une triode photosensible de l'optocoupleur (U3) est mis à la masse, et un collecteur de la triode photosensible de l'optocoupleur (U3) est connecté à un port E/S commun du module de commande central ;
un deuxième ensemble du module de détection à optocoupleur comprend un optocoupleur (U4), une résistance (R18), une résistance (R19) et une résistance (R32), une interface NCL du contrôleur d'interface PoE-PD (U11) est connectée au port de sortie positif du module redresseur par l'intermédiaire d'une diode électroluminescente de l'optocoupleur (U4), de la résistance (R19), de la résistance (R18) connectées successivement en série, un émetteur d'une triode photosensible de l'optocoupleur (U4) est mis à la masse, un collecteur de la triode photosensible de l'optocoupleur (U4) est connecté à une alimentation de 3.3V par l'intermédiaire de la résistance (R32), et le collecteur de la triode photosensible de l'optocoupleur (U4) est connecté à un port E/S commun du module de commande central ;
un troisième ensemble du module de détection à optocoupleur comprend un optocoupleur (U7), une résistance (R21), une résistance (R20) et une résistance (R35), une interface NCM du contrôleur d'interface PoE-PD (U11) est connectée au port de sortie positif du module redresseur par l'intermédiaire d'une diode électroluminescente de l'optocoupleur (U7), de la résistance (R21) et de la résistance (R20) connectées successivement en série, un émetteur d'une triode photosensible de l'optocoupleur (U7) est mis à la masse, un collecteur de la triode photosensible de l'optocoupleur (U7) est connecté à une alimentation de 3.3V par l'intermédiaire de la résistance (R35), et le collecteur de la triode photosensible de l'optocoupleur (U7) est connecté à un port E/S commun du module de commande central ; et
un quatrième ensemble de module de détection à optocoupleur comprend un optocoupleur (U8), une résistance (R23), une résistance (R22) et une résistance (R38), une interface LCF du contrôleur d'interface PoE-PD (U11) est connectée au port de sortie positif du module redresseur par l'intermédiaire d'une diode électroluminescente de l'optocoupleur (U8), de la résistance (R23) et de la résistance (R22) connectées successivement en série, un émetteur d'une triode photosensible de l'optocoupleur (U8) est mis à la masse, un collecteur de la triode photosensible de l'optocoupleur (U8) est connecté à une alimentation de 3.3V par l'intermédiaire de la résistance (R38), et le collecteur de la triode photosensible de l'optocoupleur (U8) est connecté à un port E/S commun du module de commande central.

7. Nouveau testeur POE & de câble avec test de norme BT selon la revendication 6, dans lequel un condensateur de filtrage (C22) est connecté entre le port de sortie positif du module redresseur et la masse.

8. Nouveau testeur POE & de câble avec test de norme BT selon la revendication 1, dans lequel un tube TVS (D9) est connecté entre une grille du transistor MOS (Q5) et la masse.
